# EUROPEAN PATENT APPLICATION

(11) **EP 2 278 709 A1**
(43) Date of publication of application: **26.01.2011**
(21) Application number: 09164419.5
(22) Date of filing: 02.07.2009
(51) Int. Cl.: H03H 9/21, H03H 9/02, H03H 3/02

(54) **Piezoelectric thin-film tuning fork resonator**

(71) Applicant: Micro Crystal AG, 2540 Grenchen (CH)
(72) Inventor: Dalla Piazza, Silvio, 2610 St-Imier (CH); Staub, Felix, 3425 Koppigen (CH)
(74) Representative: Ravenel, Thierry Gérard Louis

(57) **Abstract**

The piezoelectric thin-film tuning fork resonator (40) comprises an integral tuning fork made out of a quartz crystal. The tuning fork comprises a base (48) and a pair of parallel vibrating arms (44, 46) extending from the base. Each of the vibrating arms carries:
- first and second electrodes (62, 64) provided on at least one main surface of the arm, said first and second electrodes being formed respectively on an inner portion and on an outer portion of said one main surface, in such a way as to be spaced apart,
- first and second piezoelectric thin films (66, 68) formed over the first and second electrodes respectively,
- third and fourth electrodes (70, 72) formed over the first and second piezoelectric thin films respectively.

## Description

### FIELD OF THE INVENTION

The present invention generally concerns piezoelectric thin-film resonators. The present invention more specifically concerns such resonators comprising an integral tuning fork, at least a first electrode arranged on each vibrating arm of the tuning fork, at least one thin film of piezoelectric material formed on each vibrating arm over the first electrode, and at least a second electrode formed on each vibrating arm over the piezoelectric thin film; the first and second electrodes being connected in such a way that applying of an alternating voltage causes the tuning fork to vibrate.

### BACKGROUND OF THE INVENTION

Resonators corresponding to the above definition are known from the prior art. Patent document US 7,002,284 discloses a piezoelectric thin-film resonator comprising a tuning fork having at least two tines (also called vibrating arms) and at least one stem (or base) coupling the tines. The tuning fork is made out of silicon. It is obtained by etching a (110) crystal plane Si wafer. A first electrode in the form of a .5 µm metal layer is arranged over the Si crystal on each tine of the tuning fork. A 2-3 µm-thick layer of piezoelectric lead zirconate titanate (PZT) is formed on each tine over the first electrode. Finally, a second electrode in the form of a .3 µm layer of titanium and gold is formed on each tine over the PZT thin film.

One known problem with this type of resonator made from silicon is that the Young Modulus for silicon has a relatively large temperature coefficient (TCE). The TCE is approximately -60 ppm/°C. This means that a silicon crystal substantially softens with increasing temperature. Therefore, when a tuning fork resonator is made from a silicon crystal, its mechanical resonant frequency will drift considerably in case of an increase or a decrease in ambient temperature. A variety of approaches have been implemented for addressing this problem. In particular, patent document US 2007/0277620 teaches that the tuning fork can be a silicon-silicon dioxide composite structure. For example, silicon can form the core of the structure, while amorphous silicon dioxide is formed over the silicon and substantially surrounds the silicon. It happens that the TCE for amorphous silicon dioxide is positive, while the TCE for elemental silicon is negative. Therefore, by giving the silicon dioxide layer the proper thickness, it is possible to compensate for the frequency drift associated with changes in temperature. The actual thickness of the amorphous silicon dioxide coating that is formed on the surfaces of the silicon is generally between 5% and 10% of the thickness of the silicon.

One drawback of this known method for producing thermally compensated thin-film resonators is that the additional step of forming the silicon dioxide coating can considerably lengthen and complicate the entire production process.

### SUMMARY OF THE INVENTION

It is therefore an object of the present invention to provide a piezoelectric thin-film tuning fork resonator having a limited temperature induced frequency drift, without using a composite structure for the tuning fork.

To this end, the piezoelectric thin-film tuning fork resonator according to the present invention comprises an integral tuning fork formed by a base and a pair of parallel vibrating arms extending from said base, each of said vibrating arms carrying:
- first and second electrodes provided on at least one main surface of the arm, said first and second electrodes being formed respectively on an inner portion and on an outer portion of said one main surface, in such a way as to be spaced apart,
- first and second piezoelectric thin films formed over the first and second electrodes respectively,
- third and fourth electrodes formed over the first and second piezoelectric thin films respectively,
wherein the tuning fork is made out of a quartz crystal.

Although the temperature frequency coefficient of quartz depends on the cut, the thermal stability of a quartz crystal is generally considerably superior to that of a silicon crystal. Furthermore, it is known to cut quartz tuning forks in such a way that the frequency vs. temperature function reaches a maximum at room temperature. An advantage of such quartz tuning forks is that the first order temperature coefficient affecting the frequency is zero at room temperature. Therefore, there is no need to combine the quartz with a compensation material to mitigate the temperature-related frequency drift.

According to a particular embodiment of the present invention, the first and second piezoelectric thin films are thin films of aluminum nitride (AIN). The thickness of the first and second piezoelectric thin films is preferably in the range between 2 and 10 µm; most preferably 3 µm. Indeed, the static capacitance of a thin film tuning fork resonator is inversely proportional to the thickness of the thin films. Increasing the thickness of the piezoelectric thin film above 2 µm allows reducing the static capacitance and increasing the figure of merit. On the other hand, the thickness of the thin films is limited to approximately 10 µm by the growing time of the AIN layer as well as by the necessity to avoiding excessive motional resistance.

According to another embodiment of the present invention, the first, second, third and fourth electrodes are adapted to be connected to electronic circuitry for making each vibrating arm oscillate in the plane defined by the parallel arms. According to this embodiment, the first piezoelectric thin film runs along an inner edge of the arm and is contiguous to it, and the second piezoelectric thin film runs along an outer edge of the arm and is contiguous to it. An advantage of this arrangement is that it allows maximizing the motional capacitances of the resonator. Indeed, the motional capacitance of a thin film tuning fork resonator is proportional to the surface area of the electrodes weighed by the piezoelectric charge distribution, and the piezoelectric charge distribution itself closely corresponds to the stress distribution within the piezoelectric thin films. Simulations show that the peak values of piezoelectric charge density occur at the inner and outer edges of the vibrating arms. Therefore, any gap existing between the thin films and the edges of the vibrating arms should be the smallest possible, preferably zero.

According to a preferred version of the previous embodiment, the first and second piezoelectric thin films are formed in the shape of two strips bordering the inner and outer edges respectively, the strips being tapered towards the free end of the vibrating arm in order to maximize the motional/static capacitance ratio.

According to still other embodiments of the present invention, the layout of the first and second electrodes is specifically designed to take advantage of the piezoelectric nature of quartz. According to these particular embodiments, piezoelectric polarization of the quartz forming the vibrating arms reinforces the polarization of the piezoelectric thin films. An advantage of such an arrangement is that it allows further increasing the figure of merit of the oscillator.

### BRIEF DESCRIPTION OF THE DRAWINGS

Other features and advantages of the present invention will appear upon reading the following description, given solely by way of non-limiting example, and made with reference to the annexed drawings, in which:
- figure 1A shows a piezoelectric thin-film tuning fork resonator according to a first embodiment of the present invention;
- figure 1B shows a cross-section along the line A-A of figure 1;
- figure 2 is a schematic cross-sectional representation of the vibrating arms and piezoelectric strips of the tuning fork resonator of figures 1A and 1B;
- figure 3 is a schematic cross-sectional representation of the vibrating arms and piezoelectric strips of a tuning fork resonator according to a second embodiment of the present invention;
- figure 4 is a schematic cross-sectional representation of the vibrating arms and piezoelectric strips of a tuning fork resonator according to a third embodiment of the present invention;
- figure 5 is a schematic cross-sectional representation of the vibrating arms and piezoelectric strips of a tuning fork resonator according to a fourth embodiment of the present invention;
- figure 6 is a schematic cross-sectional representation of the vibrating arms and piezoelectric strips of a tuning fork resonator according to a fifth embodiment of the present invention;
- figure 7 is a schematic cross-sectional representation of the vibrating arms and piezoelectric strips of a tuning fork resonator according to a sixth embodiment of the present invention.

### DETAILED DESCRIPTION OF THE INVENTION

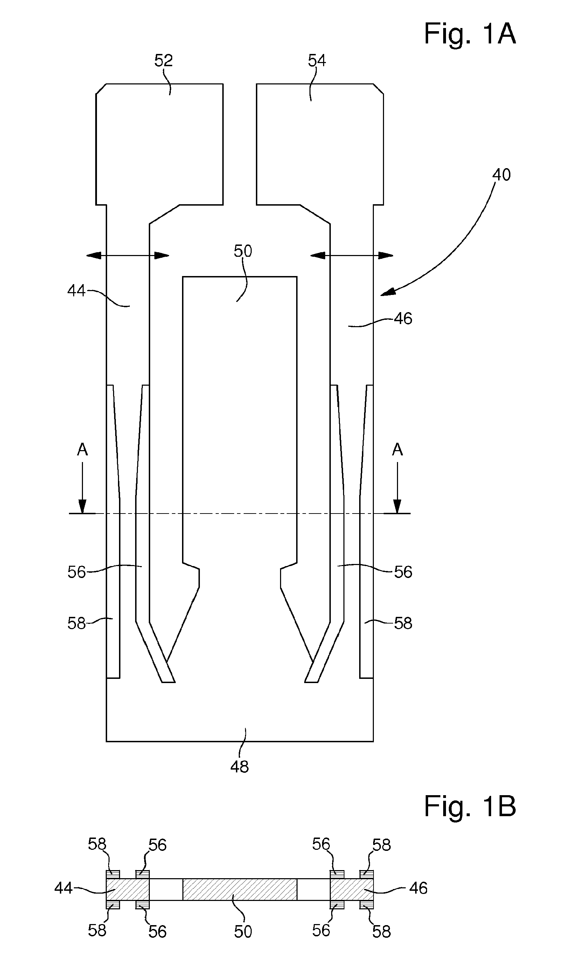

Figures 1A and 1B show a piezoelectric thin-film tuning fork resonator according to a first embodiment of the invention. The resonator 40 includes a tuning fork shaped part with two vibrating arms 44 and 46 joined by a base 48. A fixed central arm 50 is further attached to the base in between the vibrating arms. The whole assembly is made out of a single piece of quartz.

In the illustrated example, the free end of each vibrating arm 44, 46 carries a flipper (referenced 52 and 54 respectively). By adding mass to the end of the vibrating arms, the flippers make it possible to reduce the length of the arms without altering the performances of the resonator. The presence of the flippers also ensures a better distribution of the mechanical stress along the arms.

As previously mentioned, the illustrated resonator comprises a central arm 50 that is located between arms 44 and 46 and is connected to the base 48. Central arm 50 is a fixing arm that is used for fixing resonator 40 to a support. As shown, the width of central arm 50 is preferably slightly more than twice that of an arm 44 or 46 of the tuning fork shaped part. Furthermore, the length of central arm 50 is less then that of arms 44 and 46, so as to provide clearance for the flippers 52, 54. It should be understood however that the present invention applies equally well to resonators that do not comprise a central arm and/or do not comprise flippers.

According to the present invention, first and second piezoelectric thin films are arranged on at least one main surface of each vibrating arm 44, 46. In the present description, the expression "main surface" is used to designate one or the other of the two surfaces of each arm, which are parallel to the plane of the resonator. In other words, the main surfaces of the vibrating arms correspond to the top and bottom sides of the arms as shown in figure 1B. As will be explained in more detail further on, in the present example, the first and second thin films are each sandwiched between two electrodes so as to form first and second piezoelectric strips (referenced 56 and 58 respectively). As shown in figure 1B, in the present embodiment, both the top and the bottom main surfaces of each vibrating arm carry first and second piezoelectric strips.

Figures 1A shows that a first piezoelectric strip 56 extends along the inner edge of the top main surface of each vibrating arm 44, 46, while a second piezoelectric strip 58 extends along the outer edge. In the present description, the expression "inner edge" is used to designate the lateral edge of a vibrating arm 44, 46 that faces the central arm 50, and the expression "outer edge" is used to designate the lateral edge of a vibrating arm that faces away from the central arm. As further shown, the first and second piezoelectric strips are arranged so that one side of the first piezoelectric strip 56 is aligned with the inner edge, and one side of the second piezoelectric strip 58 is aligned with the outer edge. In other words, there is no gap between the strip 56 and the inner edge of the vibrating arms. Likewise, there is no gap between the strip 58 and the outer edge of the vibrating arms.
Figure 1A further shows that the piezoelectric strips 56, 58 do not extend over the entire length of the arms 44, 46. Rather, each piezoelectric strip extends between a fist location in the vicinity of where a vibrating arm 44, 46 is connected to the base 48, and a second location approximately half-way to the distal end of the arm (including the flipper). Although figure 1A shows only the top main surfaces of the arms, the piezoelectric thin-film tuning fork resonator according to the illustrated embodiment is symmetric. It follows that the arrangement of the piezoelectric strips 56, 58 on the bottom main surface of the arms 44, 46 is identical to the arrangement just described in relation to the top main surface.

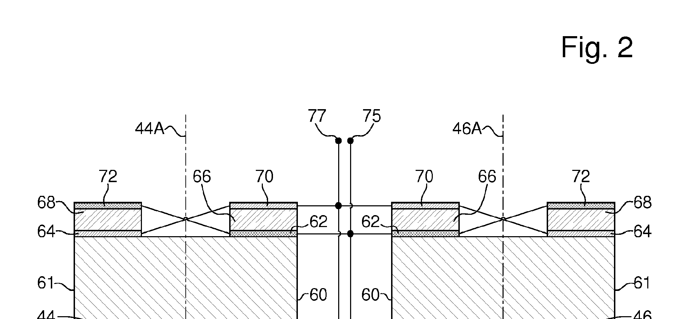

Figure 2 is a schematic cross-sectional representation showing in greater detail the piezoelectric strips arranged on the vibrating arms of the tuning fork resonator of the present example. Each arm 44 or 46 comprises a top main surface, a bottom main surface, an inner edge 60 and an outer edge 61. For ease of comprehension, each vibrating arm is divided into halves by an imaginary plane (referenced 44A or 46A) that is perpendicular to both to the main surfaces and the plane of the drawing. Imaginary planes 44A and 46A divide the top and bottom main surfaces of each arm into inner and outer portions, inner portions being on the side of the inner edge 60 of each arm, and outer portion being on the side of the outer edge 61.

With reference to Figures 1A, 1B and 2, a possible method of manufacturing the crystal resonator which is shown in Figure 1A and 1B will be explained below.

A quartz crystal substrate is first formed to a predetermined thickness. Then, a first metal film is formed over the top and bottom surfaces of the substrate. The metal film can be made from any adequate metal or alloy, platinum for example. The film can be formed using a vacuum deposition method, or sputtering, or any other adequate method known to the person skilled in the art. A piezoelectric thin film is then grown over the entire surface of the top and bottom metal films. The piezoelectric thin films are preferably AIN. However, any other appropriate piezoelectric material can be used for the thin films. The thickness of the piezoelectric thin films preferably lies in the range between 2 and 10 µm; most preferably approximately 3 µm. A second metal film, possibly chromium, is then deposited over the entire surface of each piezoelectric thin film. Preferably, a third metal film made of gold (Au) is then formed over the second metal film on both sides of the substrate.

The entire surface of the outermost metal films is then covered with a photoresist, and the photoresist is patterned to form an etching mask on either side of the substrate. The structure formed by the substrate and the various films formed over its main surfaces is then etched layer by layer, by means of wet or dry etching. The result is a batch of tuning-fork shaped resonators. The remaining photoresist is then removed from the resonators (for example by immersing them in a solvent) exposing the metal films. The resulting structure is represented in cross-section in figure 2.

Referring again to figure 2, one can see that, after etching, the remaining portions of the first metal films form first electrodes 62 bordering the inner edge 60 of each vibrating arm, and second electrodes 64 bordering the outer edge 61. In a similar fashion, the remaining portions of the second and third metal films form third electrodes 70 over the first electrodes and fourth electrodes 72 over the second electrodes. As shown in figure 2, the remaining portions of the piezoelectric thin films (referenced 66 and 68) are sandwiched between the first and third electrodes and the second and fourth electrodes respectively.

One will understand that the four structures formed each by a first electrode 62, a third electrode 70 and a first piezoelectric thin film 66 sandwiched between them, correspond to the first piezoelectric strips 56 mentioned in relation to figure 1A and 1B. Furthermore, in a similar fashion, the four structures formed each by a second electrode 64, a fourth electrode 72 and a second piezoelectric thin film 68 sandwiched between them, correspond to the second piezoelectric strips 58. As can be clearly seen in figure 2, according to the illustrated example, the inner side of each first piezoelectric strip 56 is aligned with an inner edge 60, and the outer side of each second piezoelectric strip 58 is aligned with an outer edge. The first and second piezoelectric strips on any particular main surface are spaced apart.

As shown in figure 2, according to the illustrated embodiment, the four first electrodes 62 on one tuning fork and the four fourth electrodes 72 on the same tuning-fork are connected together, while the four second electrodes are connected together and further to the four third electrodes. One possible way of implementing these connections is to deposit conductive tracks of metal film using a vapor deposition mask. The conductive tracks are preferably formed between the piezoelectric strips and the base 48. The first and fourth electrodes are further connected to one of the poles 75 of a source of electrical excitation, and the second and third electrodes are connected to the other pole 77 of the source of electrical excitation. In operation, the electrical excitation produces alternating electrical fields between the first and the third electrodes on the one hand, and between the second and fourth electrodes on the other hand. The alternating electrical fields cause the first piezoelectric strips 56 and the second piezoelectric strips 58 to shrink and expand cyclically in the longitudinal direction with a phase displacement of a half period between them.

As previously explained, a first piezoelectric strip 56 is located on the inner portion of the top and bottom main surfaces of each arm 44, 46, and a second piezoelectric strip 58 is located on the outer portion. It follows that whenever the first piezoelectric strips are expanding (longitudinally), the second piezoelectric strips are shrinking, and the two vibrating arms are forced to bend outwards, away from the central arm 50. Conversely, whenever the first piezoelectric strips 56 are shrinking, the second piezoelectric strips 58 are expanding, and the vibrating arms are forced to bend inwards, in the direction of the central arm 50. An advantage of this arrangement of piezoelectric strips is that there is hardly any coupling between the desired flexion mode of oscillation and other modes of oscillation. It should be understood however that by arranging or connecting the piezoelectric thin films differently, it is possible to make the arms vibrate in a different flexure mode or in a torsion mode, a shearing mode, etc.

According to the present invention, the vibrating arms of the resonator are made out of a quartz crystal. As quartz crystal is a piezoelectric material, whenever the vibrating arms bend inwards or outwards, a piezoelectric effect causes the surfaces of the vibrating arms to be polarized. The arrows shown in figure 3 are intended to illustrate schematically the electric field lines associated with this piezoelectric polarization. The vibrating arms 44 and 46 oscillate symmetrically, that is to say with a phase displacement of a half period between them. Therefore, at any given instant, the induced electrostatic field lines in the two vibrating arms are polarized in opposite directions. The oscillating polarization in the vibrating arms 44, 46 basically amounts to electric charge alternatively appearing on, and disappearing from, the surfaces of the vibrating arms. Furthermore, at resonance, the piezoelectric charge appears and disappears in phase with one of the poles 75, 77 (figure 2) of the source of electrical excitation connected to the resonator.

As the alternating piezoelectric polarization of the bulk quartz is in phase with the polarization of the piezoelectric thin films 66, 68, the two polarization effects are susceptible to reinforce each other in such a way as to increase the figure of merit of the oscillator. However, the piezoelectric coefficient of AIN is a great many times that of quartz. Furthermore, the arrangement of the electrodes illustrated in figure 2 is absolutely not optimized for taking advantage of the piezoelectric effect in the bulk quartz. Therefore, the piezoelectric nature of quartz hardly has any noticeable effect on the performance of the resonator according the embodiment of the invention illustrated in figures 1A, 1B and 2. However, the thin-film resonators according to the present invention, which will now be discussed with reference to figures 3, 4 and 5, are specifically designed to take advantage of the piezoelectric nature of quartz.

The thin-film tuning fork resonator schematically represented in figure 3 corresponds to a second embodiment of the present invention. The resonator of figure 3 differs from that of figure 2 in that the first electrodes 162 on the main surfaces of vibrating arm 44 are joined together by an additional lateral portion 162a that covers the inner side (or edge) 60 of the vibrating arm 44. Furthermore, in a similar fashion, the second electrodes 164 on the main surfaces of vibrating arm 46 are joined together by an additional lateral portion 164a that covers the outer side (or edge) 61 of the vibrating arm 46. Considering the general layout of the electrostatic field lines represented in figure 3, it is straightforward to understand that the presence on one side of each arm of an additional lateral electrode portion increases the piezoelectric coupling between the quartz and the source of electrical excitation connected to the electrodes.

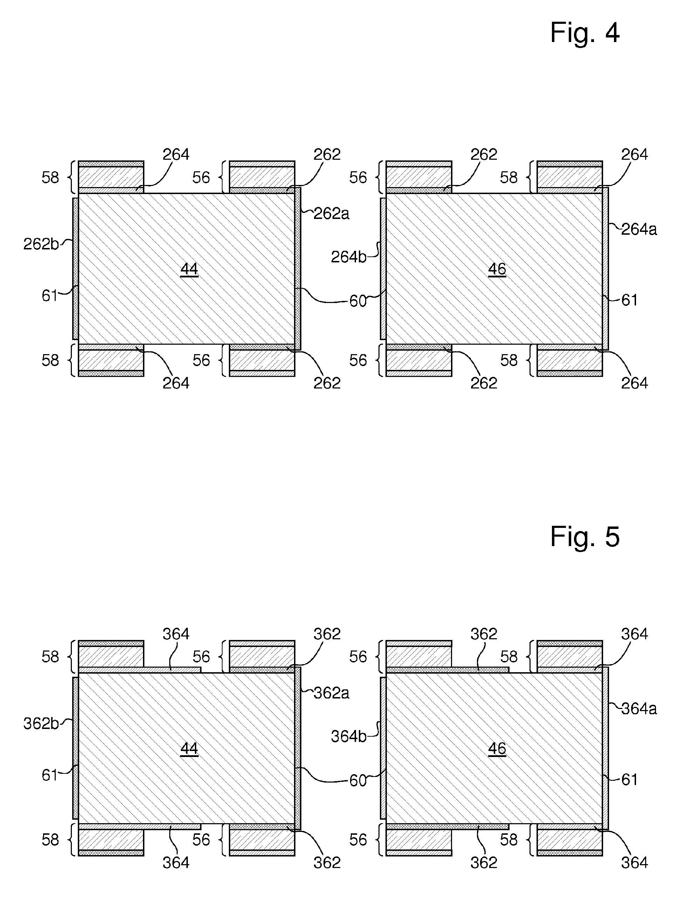

The thin-film tuning fork resonator schematically represented in figure 4 corresponds to a third embodiment of the present invention. The resonator of figure 4 differs from that of figure 3 in that a first lateral electrode 262b is formed over the outer side (or edge) 61 of vibrating arm 44 opposite the additional lateral portion 262a, and in that in a similar fashion a second lateral electrode 264b is formed over the inner side (or edge) 60 of vibrating arm 46 opposite the additional lateral portion 264a. The first lateral electrode 262b is connected to the other first electrodes and the second lateral electrode 264b is connected to the other second electrodes. One possible way of implementing these connections is to deposit conductive tracks of metal film (not shown) using a vapor deposition mask. The conductive tracks are preferably formed between the electrodes and the base 48. Referring again to figure 3 and to the general layout of the electrostatic field lines, it is straightforward to understand that the presence on both sides 60, 61 of each arm 44, 45 of lateral electrodes 262a, 262b, 264a, 264b increases the piezoelectric coupling between the quartz and the source of electrical excitation connected to the electrodes.

The thin-film tuning fork resonator schematically represented in figure 5 corresponds to a fourth embodiment of the present invention. The resonator of figure 5 differs from that of figure 4 in that the second electrode 364 on either main surface of vibrating arm 44 comprises a center portion formed over the main surface of the arm in between the first and second piezoelectric strips 56, 58, and in that, in a similar fashion, the first electrode 362 on either main surface of vibrating arm 46 comprises a center portion formed over the main surface in between the first and second piezoelectric strips 56, 58. Referring again to figure 3 and to the general layout of the electrostatic field lines, it is straightforward to understand that by increasing the fraction of the main surface covered by electrodes it is possible to increase the piezoelectric coupling between the quartz and the source of electrical excitation connected to the electrodes.

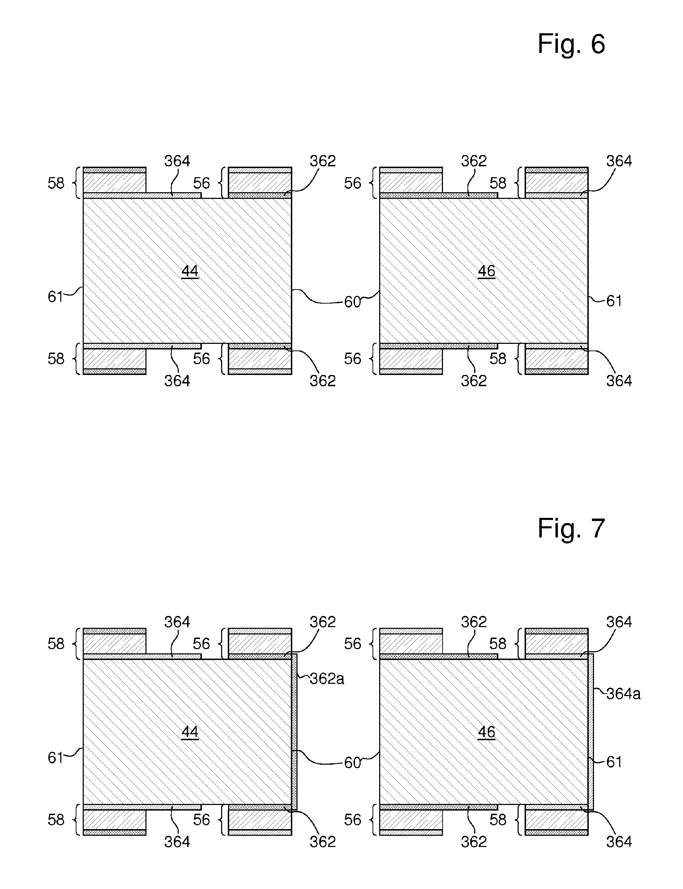

It will be understood that various alterations and/or improvements evident to those skilled in the art could be made to the embodiment that forms the subject of this description without departing from the scope of the present invention defined by the annexed claims. In particular, the electrodes 362 and 364 described in relation to the above-described fourth embodiment could be introduced into the second embodiment (as shown in figure 6) or into the third embodiment (as shown in figure 7).

## Claims

1. A piezoelectric thin-film tuning fork resonator (40) comprising an integral tuning fork formed by a base (48) and a pair of parallel vibrating arms (44, 46) extending from said base, each of said vibrating arms carrying:
- first and second electrodes (62, 64; 162, 164; 262, 264; 362, 364) provided on at least one main surface of the arm, said first and second electrodes being formed respectively on an inner portion and on an outer portion of said one main surface, in such a way as to be spaced apart,
- first and second piezoelectric thin films (66, 68) formed over the first and second electrodes respectively,
- third and fourth electrodes (70, 72) formed over the first and second piezoelectric thin films respectively;
**characterized in that** the tuning fork is made out of a quartz crystal.

2. The piezoelectric thin-film resonator of claim 1, wherein the first and second piezoelectric thin films (66, 68) comprise aluminum nitride, and each have a thickness in a range between 2 and 10 µm.

3. The piezoelectric thin-film resonator of claim 1, wherein the first piezoelectric thin film (66) runs along an inner edge (60) of the vibrating arm and is contiguous to it, and the second piezoelectric thin film (68) runs along an outer edge (61) of the vibrating arm and is contiguous to it, and wherein the first (62; 162; 262; 362), second (64; 164; 264; 364), third (70) and fourth (72) electrodes are connected to electronic circuitry adapted to make each vibrating arm (44, 46) oscillate in a plane subtended by the pair of vibrating arms (44, 46).

4. The piezoelectric thin-film resonator of claim 3, wherein the first and second piezoelectric thin films (66, 68) are formed in the shape of two strips (56, 58) bordering the inner and outer edges (60, 61) respectively, the strips being tapered towards the free end of each vibrating arm (44, 46).

5. The piezoelectric thin-film resonator of claim 1, wherein the first and second electrodes (62, 64; 162, 164; 262, 264; 362, 364), the first and second piezoelectric thin-films (66, 68), the third and fourth electrodes (70, 72) are arranged substantially symmetrically to each other on either side of a longitudinal center line of said one main surface.

6. The piezoelectric thin-film resonator of claim 1, wherein each of said vibrating arms comprises an inner edge (60) and an outer edge (61), wherein said first electrodes (162; 262; 362) on either main surface of one of said vibrating arms (44) are joined by an inner lateral portion (162a; 262a; 362a) formed over the inner edge (60) of said one (44) of said vibrating arms, and wherein said second electrodes (164; 264; 364) on either main surface of the other of said vibrating arms (46) are joined by an outer lateral portion (164a; 264a; 364a) formed over the outer edge (61) of said other one (46) of said vibrating arms.

7. The piezoelectric thin-film resonator of claim 6, wherein a first lateral electrode (262b; 362b) is formed over the outer edge (61) of said one (44) of said vibrating arms, said first lateral electrode being connected to said first electrodes (262; 362), and wherein a second lateral electrode (264b; 364b) is formed over the inner edge (60) of said other one (46) of said vibrating arms, said second lateral electrode being connected to said second electrodes (264; 364).

8. The piezoelectric thin-film resonator of claim 1, wherein said second electrodes (364) on either main surface of said one (44) of said vibrating arms comprises a center portion formed over the main surface in between the first and second thin films (66, 68), and wherein said first electrodes (362) on either main surface of said other one (46) of said vibrating arms comprises a center portion formed over the main surface in between the first and second thin films (66, 68).

9. The piezoelectric thin-film resonator of claim 6, wherein said second electrodes (364) on either main surface of said one (44) of said vibrating arms comprises a center portion formed over the main surface in between the first and second thin films (66, 68), and wherein said first electrodes (362) on either main surface of said other one (46) of said vibrating arms comprises a center portion formed over the main surface in between the first and second thin films (66, 68).

10. The piezoelectric thin-film resonator of claim 7, wherein said second electrodes (364) on either main surface of said one (44) of said vibrating arms comprises a center portion formed over the main surface in between the first and second thin films (66, 68), and wherein said first electrodes (362) on either main surface of said other one (46) of said vibrating arms comprises a center portion formed over the main surface in between the first and second thin films (66, 68).
